# EUROPEAN PATENT SPECIFICATION

(11) **EP 4 510 185 B1**
(45) Date of publication and mention of the grant of the patent: **23.09.2026**
(21) Application number: 24193418.1
(22) Date of filing: 07.08.2024
(51) Int. Cl.: H10W 70/60, H10W 90/00

(54) **POWER OVERLAY STRUCTURE FOR A MULTI-CHIP SEMICONDUCTOR PACKAGE**
LEISTUNGSÜBERLAGERUNGSSTRUKTUR FÜR EIN MEHRCHIP-HALBLEITERGEHÄUSE
STRUCTURE DE RECOUVREMENT DE PUISSANCE POUR UN BOÎTIER DE SEMI-CONDUCTEUR MULTIPUCE

(30) Priority: 16.08.2023 US 202318234603
(43) Date of publication of application: 19.02.2025
(73) Proprietor: General Electric Company, Evendale, Ohio 45215 (US)
(72) Inventor: STEVANOVIC, Ljubisa, Niskayuna, 12309-1027 (US); GOWDA, Arun Virupaksha, Niskayuna, 12309-1027 (US); KAPUSTA, Christopher James, Niskayuna, 12309-1027 (US); TUOMINEN, Risto Ilkka Sakari, Niskayuna, 12309-1027 (US)
(74) Representative: Openshaw & Co.

(56) References cited:
- JP-A- 2007 288 046
- US-A1- 2010 109 052
- US-A1- 2016 126 212
- US-A1- 2022 115 298
- US-B1- 11 177 188

## Description

### BACKGROUND

The present disclosure relates generally to semiconductor packages, and more particularly to a multi-chip semiconductor package having an interconnecting power overlay structure.

Power semiconductor devices, such as switches and rectifiers, are key components of power electronic circuits (e.g., switched mode power supplies, inverters, rectifiers, and the like). High power applications typically require multi-chip assemblies comprising multiple power semiconductor devices connected together to carry large amounts of current and to support high voltages. When connecting individual devices into multi-chip assemblies, it is important to maintain layout symmetry and low inductance interconnect in order to ensure good load sharing, minimize voltage and current overshoots, and reduce switching losses. A top surface of each power semiconductor device, such as metal oxide semiconductor field effect transistor (MOSFET), includes a gate pad and at least one source pad which are electrically connected to gate and source pads of other devices in the multi-chip assembly. The electrical connections of multiple gate pads and source pads are typically formed using wire bonds and complex routing configurations to a common gate pad and at least one common source pad. The common gate pad and at least one common source pad of the multi-chip semiconductor assembly may be connected to an external power electronic circuit such that the multi-chip semiconductor assembly operates as a singular power processing unit.

An alternative to the wire bonding of gate pads and source pads may be the use of one or more planar interconnect layers separated by interconnect layers disposed over the top surfaces of the semiconductor devices. The interconnect layers may include metallization vias which extend through the interconnect layer to electrically couple the source pads and gate pads to the common gate pad and the common source pad disposed on upper interconnect layers of the multi-chip semiconductor assembly to deliver power to the semiconductor devices through the metallization vias.

To establish a proper electrical connection to external power electronic circuitry, the common gate pad and the common source pad on an uppermost interconnect layer require sufficient surface area to solder, sinter, copper-bond, copper-clip, or otherwise connect the common gate pad and the source pad of the multi-chip assembly with the external power electronic circuitry. However, the available surface area of the common gate pad and the common source pad are generally limited by the overall surface area of the multi-chip semiconductor assembly. Further, direct soldering, sintering, copper-bonding, and copper-clipping onto smaller common gate pads and common source pads introduce bonding stresses onto the multi-chip semiconductor assembly and form less reliable interconnections.

Additionally, connecting together multiple gate pads into the common gate pad and multiple source pads into the common source pad of a multi-chip semiconductor assembly requires good layout symmetry resulting in matched inductances of individual connections to ensure good load sharing among individual devices. Realizing high current power modules requires paralleling multiple semiconductor devices. For example, building a 480A power module will require paralleling of eight devices, each rated for approximately 60A. Paralleling eight devices is challenging from the aspect of ensuring all eight devices share current equally, due to their varying individual characteristics and the challenge to connect each device to the external power electronic circuitry such that each switch receives the signal to turn on or off at the same time. This is driven by gate-source parasitic impedance, which is driven by the geometry of traces connections between devices. The more devices in parallel, the more complicated it is to balance the impedance to ensure each device switches at the same time and shares current. One solution is to parallel two larger semiconductor devices, each rated at approximately 240A. A device rated at 240A is significantly larger than a device rated for 60A. This will make the packaging and interconnection easier, however, the device yield will be significantly lower.

Finally, semiconductor fabrication processes inherently result in varying characteristics of individual semiconductor devices within wafer and wafer-to-wafer. Therefore, building multi-chip semiconductor assemblies from individual devices with similar characteristics will further maintain full performance of individual devices within a multi-chip assembly.

US2010/109052A1 describes a technique for reducing the size of a semiconductor device used in a power amplifier circuit. In the semiconductor device, a source pad, a drain pad and a gate pad are formed in a layer upper than gate electrodes on a main surface of a semiconductor substrate.

US2016/126212A1 describes chip assemblage. A top main electrode is arranged on the top side and each of the semiconductor chips has a control electrode. The chip assemblage additionally comprises a common control terminal, and a common reference potential terminal. The common control terminal is electrically conductively connected to each of the control electrodes via a control electrode interconnection structure.

### BRIEF DESCRIPTION

In one aspect, a multi-chip semiconductor package is disclosed. The package includes an interconnect layer having an upper surface and a bottom surface, wherein the interconnect layer includes a dielectric material, at least one common source pad disposed on the upper surface of the interconnect layer, at least one common gate pad disposed on the upper surface of the interconnect layer, and a plurality of semiconductor devices each including a gate pad and at least one source pad adhered onto the interconnect layer, wherein the source pads of the plurality of semiconductor devices are electrically connected to the at least one common source pad, and wherein the source pads of the plurality of semiconductor devices are electrically connected in parallel with one another, and wherein the gate pads of the plurality of semiconductor devices are electrically connected to the common gate pad, and wherein the gate pads of the plurality of semiconductor devices are electrically connected in parallel with one another.

In another aspect, a method of manufacturing a multi-chip semiconductor package is disclosed. The method includes forming at least one source via pathway and at least one gate via pathway through an interconnect layer, aligning at least one source pad and a gate pad of a plurality of semiconductor devices with the least one source via pathway and the at least one gate via pathway, respectively, and adhering the plurality of semiconductor devices to the interconnect layer, wherein a surface area of the interconnect layer is substantially equal to a surface area of a footprint defined by the plurality of semiconductor devices

### BRIEF DESCRIPTION OF THE DRAWINGS

The subject-matter of the disclosure will be explained in more detail in the following text with reference to exemplary embodiments which are illustrated in the attached drawings.
FIG. 1 is a perspective view of one embodiment of a semiconductor device;
FIG. 2 is perspective view of a one embodiment of a molding of a multi-chip semiconductor package;
FIG. 3 is a perspective view of one embodiment of a multi-chip semiconductor package;
FIG. 4 is a plan view of the multi-chip semiconductor package of FIG. 3;
FIG. 5 is an exploded view of the multi-chip semiconductor package of FIG. 3;
FIG. 6 is an exploded view of the multi-chip semiconductor package of FIG. 3;
FIG. 7 is a cross-sectional view of the multi-chip semiconductor package of FIG. 3 taken along line A-A';
FIG. 8 is a cross-sectional view of the multi-chip semiconductor package of FIG. 3 taken along line B-B';
FIG. 9A is a plan view of an example interconnect layer and associated routing in accordance with one or more embodiments of the present disclosure;
FIG. 9B is a translucent plan view of an example interconnect layer and associated routing in accordance with one or more embodiments of the present disclosure;
FIG. 9C is a cross-sectional view of the interconnect layer and associated routing of FIG. 9B taken along line C-C';
FIG. 9D is a cross-sectional view of the interconnect layer and associated routing of FIG. 9B taken along line D-D';
FIG. 10A is a plan view of an example interconnect layer and associated routing in accordance with one or more embodiments of the present disclosure;
FIG. 10B is a plan view of an example interconnect layer and associated routing in accordance with one or more embodiments of the present disclosure;
FIGS. 11 and 12 are plan views of an example interconnect layer and associated routing in accordance with one or more embodiments of the present disclosure;
FIG. 13A is a plan view of an example first interconnect layer and associated routing in accordance with one or more embodiments of the present disclosure;
FIG. 13B is a plan view of an example interconnect layer and associated routing in accordance with one or more embodiments of the present disclosure;
FIG. 13C is a plan view of an example interconnect layer and associated routing in accordance with one or more embodiments of the present disclosure;
FIGS. 14A-14B are cross-sectional views of example backside structures; and,
FIG. 15A-15B illustrate one embodiment of a method of manufacturing a multi-chip semiconductor package.

The reference symbols used in the drawings, and their meanings, are listed in summary form in the list of reference symbols. In principle, identical parts are provided with the same reference symbols in the figures.

### DETAILED DESCRIPTION

In the following specification and the claims, reference will be made to a number of terms, which shall be defined to have the following meanings.

As used herein, the singular forms "a," "an," and "the" include plural references unless the context clearly dictates otherwise. The terms "comprising," "including," and "having" are intended to be inclusive and mean that there may be additional elements other than the listed elements. The terms "optional" or "optionally" means that the subsequently described event or circumstance may or may not occur, and that the description includes instances where the event occurs and instances where it does not.

Unless otherwise indicated, approximating language, such as "generally," "substantially," and "about," as used herein indicates that the term so modified may apply to only an approximate degree, as would be recognized by one of ordinary skill in the art, rather than to an absolute or perfect degree. Accordingly, a value modified by a term or terms, such as "about," "approximately," and "substantially," is not to be limited to the precise value specified. In at least some instances, the approximating language may correspond to the precision of an instrument for measuring the value. Here and throughout the specification and claims, range limitations may be identified. Such ranges may be combined and/or interchanged, and include all the sub-ranges contained therein unless context or language indicates otherwise.

Additionally, unless otherwise indicated, the terms "first," "second," etc. are used herein merely as labels, and are not intended to impose ordinal, positional, or hierarchical requirements on the items to which these terms refer. Moreover, reference to, for example, a "second" item does not require or preclude the existence of, for example, a "first" or lower-numbered item or a "third" or higher-numbered item.

Embodiments of the disclosure relate generally to structures and methods for packaging multiple semiconductor devices and, more particularly to multi-chip semiconductor package having an interconnecting power overlay (POL) structure. The methods, systems, and apparatus described herein overcome at least some disadvantages of at least some known multi-chip semiconductor packages. More specifically, the systems and apparatus described herein provide a POL package configured as a redistribution layer (RDL) positioned directly over multiple semiconductor devices. Accordingly, the POL package is also referred to herein as a POL-RDL package. The POL-RDL package includes an oversized surface area relative to a footprint of the molding defined by the semiconductor devices (or more generally to a footprint of the semiconductor devices), which improves available surface area for placement of common gate pads, common source pads and overlayed contact pads. The oversized surface area also allows for placement of more complex configurations of common source pads, common gate pads and gate bridges, and additional interconnect layers and interconnect layers.

A multi-chip semiconductor package is disclosed. The multi-chip semiconductor package includes least one interconnect layer having an upper surface and a bottom surface, at least one common source pad disposed on the upper surface of the at least one interconnect layer, at least one common gate pad disposed on the upper surface of the at least one interconnect layer and, a plurality of semiconductor devices. Each of the semiconductor devices have a gate pad and at least one source pad adhered onto a bottom surface of a first interconnect layer of the at least one interconnect layer. The bottom surface of the first interconnect layer has an adhesive layer. The source pads of the plurality of semiconductor devices are electrically connected to the at least one common source pad, and the source pads of the plurality of semiconductor devices are electrically connected in parallel with one another. The gate pads of the plurality of semiconductor devices are electrically connected to the at least one common gate pad, and the gate pads of the plurality of semiconductor devices are electrically connected in parallel with one another.

As used herein, the term "routing" refers to metallization vias disposed within via pathways of a interconnect layer and to trace connections, pads, contacts and contact pads disposed on the interconnect layer. The routing may also include surface-mount resistors, thin film resistors and associated pads for placement of surface-mount resistors post-fabrication.

Additional interconnect layers and routing may be laminated or otherwise fabricated over a first interconnect layer to facilitate additional routing configurations. As used herein, the terms "package gate pad" and "package source pad" refer to common gate pads and common source pads on an uppermost interconnect layer which are electrically connected to external power electronic circuitry. Any of the first interconnect layer and additional interconnect layers disclosed herein may be directly connected to external power electronic circuitry or may have additional interconnect layers and routing. Therefore, the terms "package gate pad," "package source pad," "common gate pads," and "common source pads" are used interchangeably.

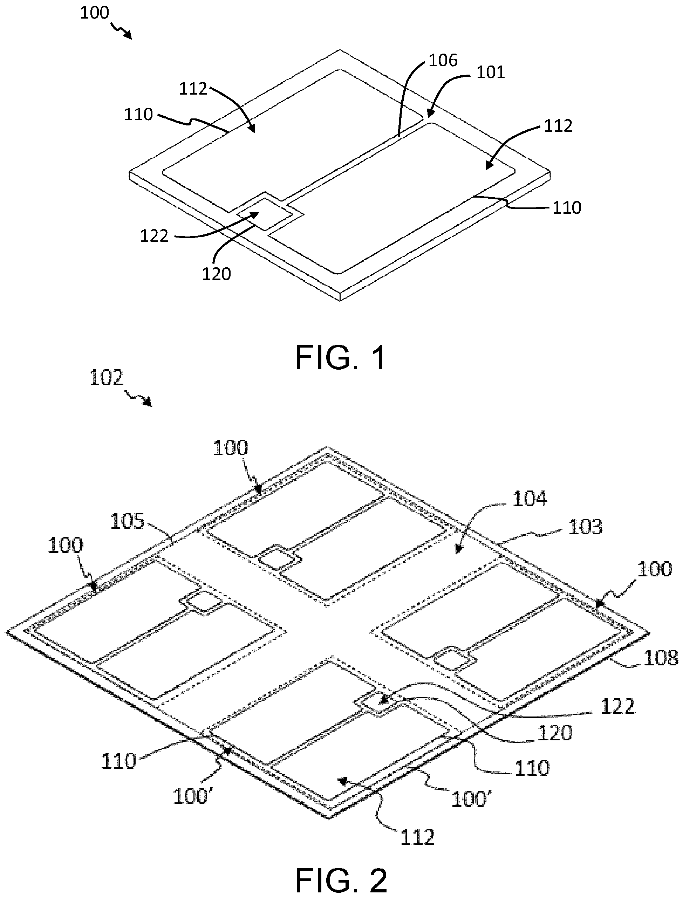

FIG. 1 illustrates a perspective view of one embodiment of a semiconductor device 100. FIG. 2 illustrates a perspective view of a molding 102 including at least two semiconductor devices 100 (also referred to as a plurality of semiconductor devices 100). As shown in FIGS. 1 and 2, the semiconductor device 100 includes a dielectric material 106 that defines an upper surface 101. The semiconductor device 100 further includes at least one source pad 110 and a gate pad 120 disposed on the upper surface 101 of the semiconductor device 100. The at least one source pad 110 includes a top contact surface 112. Likewise, the gate pad 120 includes a top contact surface 122.

The top contact surfaces 112, 122 of the gate pad 120 and each of the at least one source pad 110 are electrically isolated from each other by the dielectric material 106. In some embodiments, at least a portion of the gate pad 120 and the at least one source pad 110 at least partially extend below the upper surface 101. In some embodiments, the top contact surface 112 of the at least one source pad 110 and the top contact surface 122 of the gate pad 120 are flush with the surface of the dielectric material 106. In some embodiments, the top contact surface 112 of the at least one source pad 110 and the top contact surface 122 of the gate pad 120 are below the surface of the dielectric material 106. In some embodiments, the top contact surface 112 of the at least one source pad 110 and the top contact surface 122 of the gate pad 120 are above the surface of the dielectric material 106.

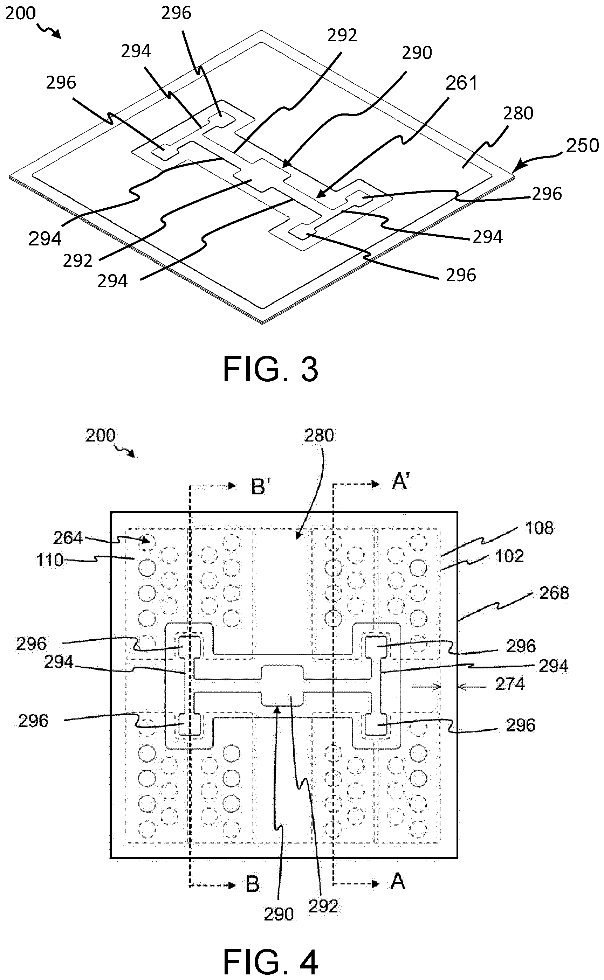

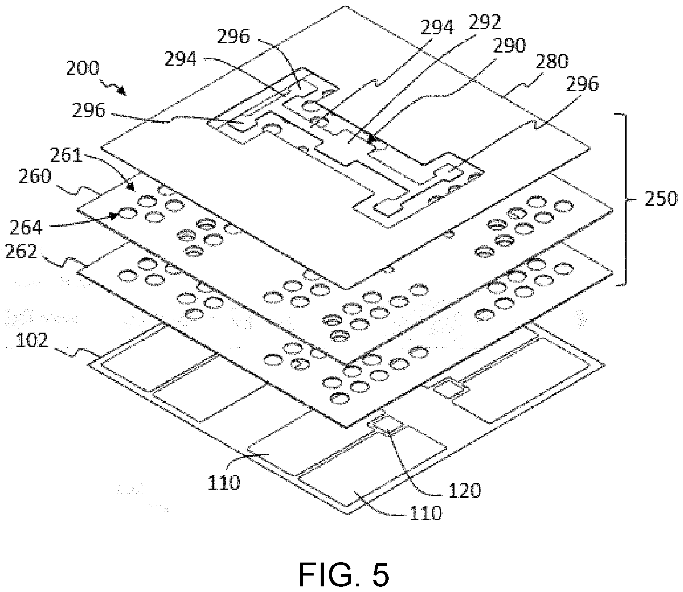

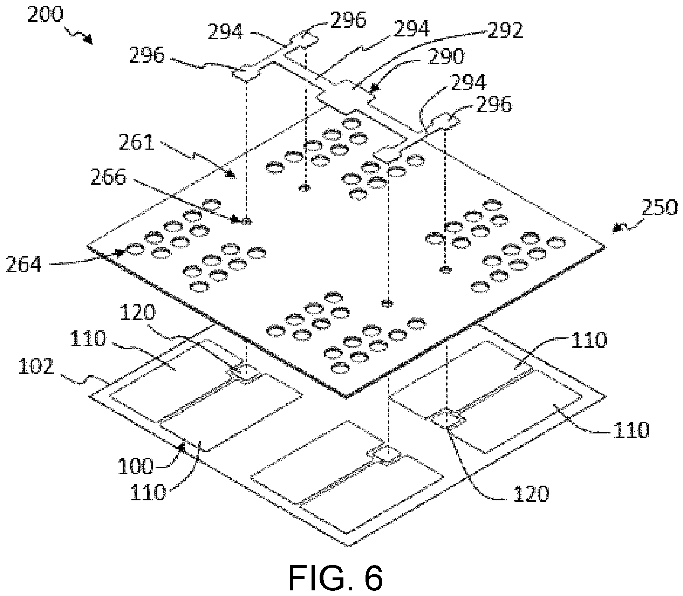

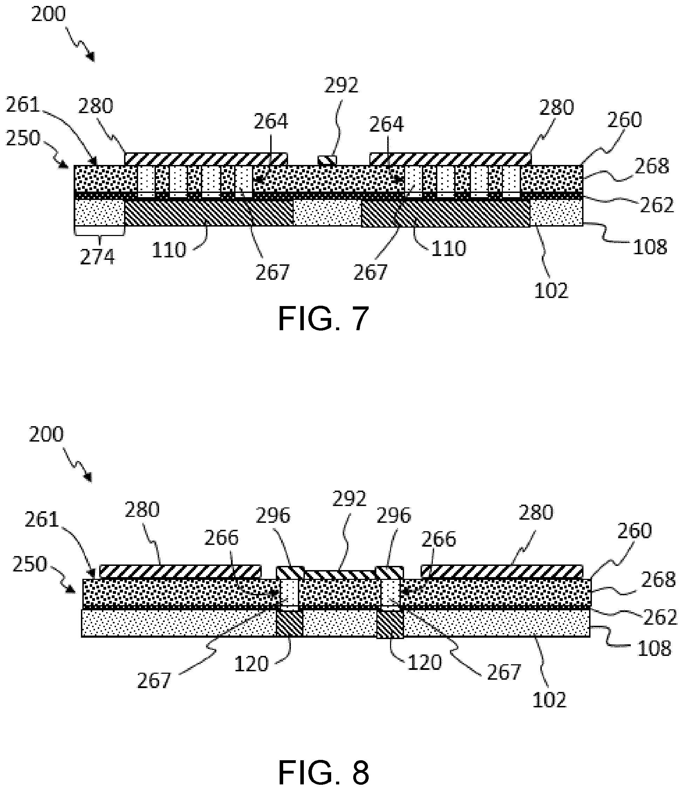

As shown in FIG. 2, the molding 102 includes a underfill material 103 that defines an upper surface 104, and a plurality of semiconductor devices 100 at least partially disposed in the molding 102 and surrounded by the underfill material 103. The plurality of semiconductor devices 100 embedded in the molding 102 define a footprint 105 (as best shown in FIG. 4). FIGS. 3-8 illustrate one or more embodiments of a multi-chip semiconductor package 200. FIG. 3 illustrates a perspective view of the multi-chip semiconductor package 200, FIG. 4 illustrates a plan, partially transparent view of the semiconductor package 200 and FIGS. 5 and 6 illustrate exploded views of the semiconductor package 200. FIGS. 7 and 8 illustrate cross-sectional views of the semiconductor package 200 taken along lines A-A' and B-B' of FIG. 4, respectively.

The multi-chip semiconductor package 200 operates as a metal-oxide-semiconductor field-effect transistor (MOSFET) having two or more semiconductor devices 100. The multi-chip semiconductor package 200 includes a POL-RDL package 250 having at least one common source pad 280 and a gate bridge 290. The POL-RDL package 250 includes a first interconnect layer 260 and an adhesive layer 262 disposed over the molding 102 (as best shown in FIG. 5). In some embodiments, the first interconnect layer 260 is in the form of a lamination or a film, and may be formed of one a plurality of dielectric materials, such as Kapton^{®} polyimide, Ultem^{®} polyetherimide, polytetrafluoroethylene (PTFE), Upilex^{®}, polysulfone materials (e.g., Udel^{®} polysulphone, Radel^{®} polyphenolsulphone), or another polymer film, such as a liquid crystal polymer (LCP), Bismaleimide-Triazine resin, Ajinomoto Build-up Film^{®} ABF or a polyimide material. In one embodiment, the POL-RDL package 250 has a total thickness in the range of 25 microns to 300 microns.

In some embodiments, the POL-RDL package 250 (which may include any number of interconnect layers 260, trace connections, source and gate pads) is fully fabricated and positioned over the molding 102 (together with the plurality of semiconductor devices 100 embedded in the molding 102), and the first interconnect layer 260 is adhered to the source pads 110 and the gate pads 120 by the adhesive layer 262. That is, the adhesive layer 262 is positioned between the first interconnect layer 260 and the molding 102. In some embodiments, the semiconductor devices 100 may be adhered directly onto the adhesive layer 262 without a molding. A molding or an underfill material may be deposited between the semiconductor devices 100 at a later stage.

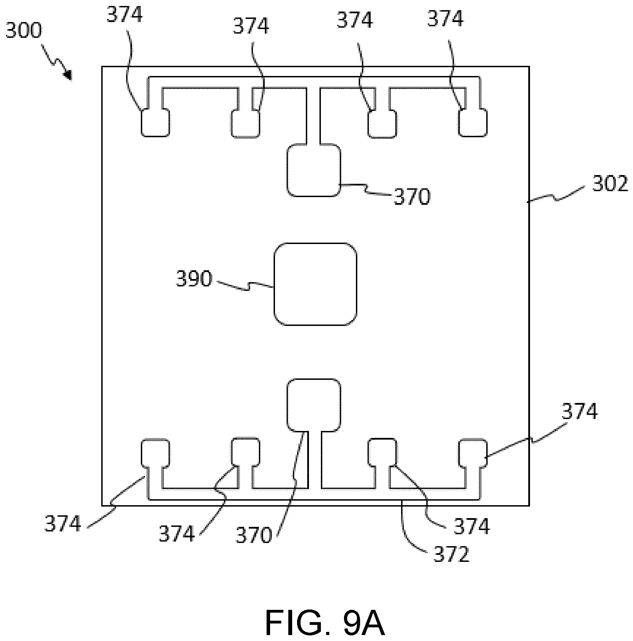

In operation, metallization vias are formed in source via pathways 264 and gate via pathways 266 extending through the first interconnect layer 260 (and in any number of additional interconnect layers as explained in further detail below with reference to FIGS. 9A - 14B), associated metal interconnect structures and routing are built over the first interconnect layer 260 (and in any number of additional interconnect layers), and the adhesive layer 262 is applied to a bottom surface of the first interconnect layer 260. The semiconductor devices 100 (either as part of the molding 102 or individually) are aligned with the source via pathways 264 and gate via pathways 266 extending through the first interconnect layer 160 in accordance with one or more configurations, and the molding 102 is cured to form the multi-chip semiconductor package 200. It is understood that any of the steps in fabrication may be performed in a different sequence. By way of example, the source via pathways 264 and gate via pathways 266 may be filled prior to aligning and adhering the semiconductor devices 100 (either as part of the molding 102 or individually).

The at least one common source pad 280 and the gate bridge 290 are formed on an upper surface 261 of the first interconnect layer 260. Source via pathways 264 and gate via pathways 266 extend through the first interconnect layer 260 and the adhesive layer 262. As best shown in FIGS. 7 and 8, the POL-RDL package 250 of the multi-chip semiconductor package 200 also includes a metal interconnect structure 267 that extends through the source via pathways 264 and the gate via pathways 266. The metal interconnect structure 267 electrically couples the top contact surface 112 of each of the source pads 110 to the at least one common source pad 280 of the POL-RDL package 250, and likewise the metal interconnect structure 267 electrically couples the top contact surface 122 of the gate pad 120 to the gate bridge 290 of the POL-RDL package 250.

In some embodiments, the metal interconnect structure 267 is formed by filling the source via pathways 264 and the gate via pathways 266 with a conductive material (i.e., conductive epoxy, paste, or solder and the like). In some embodiments, the vias have plated copper and a sputtered adhesion layer such as titanium or Ti-tungsten. In some embodiments, the metal interconnect structure 267 is formed during deposition of the at least one common source pad 280 and the gate bridge 290. By way of example, as the at least one common source pad 280 and the gate bridge 290 are deposited, the source via pathways 264 and the gate via pathways 266 are also filled. Subsequently, the at least one common source pad 280 and the gate bridge 290 are electroplated or otherwise plated or fabricated to a desired thickness.

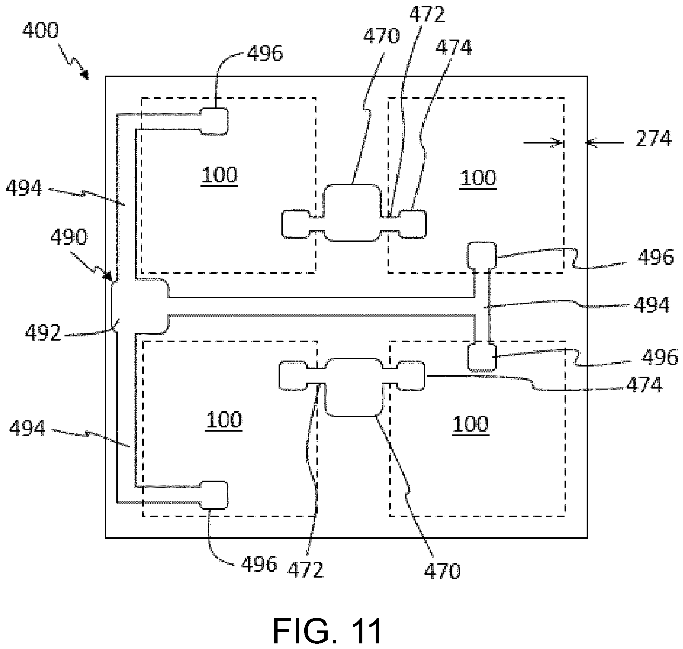

In some embodiments, the gate bridge 290 includes a common gate pad 292 and gate contacts 296 connected by trace connections 294. As best shown in FIG. 6, each of the gate contacts 296 of the gate bridge 290 are aligned with the gate pads 120 of the plurality of semiconductor devices 100. As shown in FIGS. 7 and 8, the common gate pad 292, the trace connection 294, and the gate contacts 296 are disposed on the first interconnect layer 260 of the POL-RDL package 250, and the gate contacts 296 are electrically connected to the gate pads 120 by the metal interconnect structure 267. The trace connection 294 extends from the common gate pad 292 to the gate contacts 296, and may have any number of branches and bends to establish the electrical connection between the common gate pad 292 and the gate contacts 296. In the illustrated embodiments, the gate bridge 290 has an I-shape with each end being a pair of gate contacts 296 that align with gate pads 120 of the plurality of semiconductor devices 100, however as shown in FIGS. 11 through 13A, the gate bridge 290 can have other shapes and configurations but maintain equal path lengths, as explained in further detail below.

As shown in FIG. 4, the trace connections 294 of the gate bridge 290 have the same length between the common gate pad 292 and gate contacts 296 such that there are equal resistivity values between the common gate pad 292 and gate contacts 296. The length of the trace connections 294 impacts inductance. To alternatively achieve substantially equal resistivities, the common gate pad 292 and the length of the trace connections 294 can be made similar to all the gate pads 120 of the semiconductor devices 100. However, depending on how the source is connected, it may create asymmetry in the gate source loop inductance which is a key parameter. The POL-RDL package 250 provides for flexibility in optimizing the gate-source loop inductance depending on how it is oriented and connected to the next level circuit. For example, the resistivity and trance length of two of the semiconductor devices 100 to be different than the other two semiconductor devices 100 so that the eventual gate source loops to each device is similar/equal.

To achieve trace connections 294 having equal length and equal resistivity values, the semiconductor devices 100 can be oriented or positioned on the adhesive layer 262 and the first interconnect layer 260 such that the gate pad 120 of each of the semiconductor devices are an equal length from the common gate pad 292 of the gate bridge 290. In the invention any one of the trace connections 294 includes a surface-mount resistor or a thin-film resistor to balance resistivity values.

As shown in FIGS. 2, 4, and 7, an outer peripheral edge 108 of the underfill material 103 defines a surface area of the molding 102. Each of the plurality of the semiconductor devices 100 are spaced from the outer peripheral edge 108 of the molding 102, and the placement of the plurality of the semiconductor devices 100 in the molding 102 defines a footprint 105 of the molding 102 (please note the footprint 105, as defined herein, generally has a smaller surface than the molding 102 itself). It is understood that in some embodiments, the plurality of the semiconductor devices 100 are directly adhered to the first interconnect layer 260 (and adhesive layer 262) without the use of the molding 102, and in such embodiments, the footprint 105 is defined as the placement of the plurality of semiconductor devices 100 on the bottom surface of the first interconnect layer 260. The footprint 105 is therefore defined as the outermost peripheral edges of the plurality of the semiconductor devices 100.

The first interconnect layer 260 of the POL-RDL package 250 is generally placed over the entire molding 102 and has a surface area greater than the footprint 105 of the molding 102 such that an outer peripheral edge 268 of the first interconnect layer 260 extends beyond the footprint 105 of the molding 102 and the outermost peripheral edges of the plurality of semiconductor devices 100 (please note that the outer peripheral edge 268 does not extend beyond a perimeter of the molding itself 102). In some embodiments, the adhesive layer 262 extends to the outer peripheral edge 268 of the first interconnect layer 260.

In some embodiments, the overhang region 274 of the POL-RDL package 250 increases available surface area of the first interconnect layer 260 for placement of a larger common source pad 280 and a larger common gate pad 292.The overhang region 274 also allows for placement of more complex configurations of common source pads 280, gate bridges 290, common gate pads 292 and trace connections for the common source pads 280 and common gate pads 292 as explained in further detail below. The POL-RDL package 250 thus facilitates improved routing and more robust connections of the at least one common source pad 280 and the common gate pad 292 to external power electronic circuitry or to additional interconnect layers disposed over the first interconnect layer 260 (as explained in further detail below). Connection of external power electronic circuitry - either directly onto the at least one common source pad 280 and the common gate pad 292 or by the additional interconnect layers - enables the source pads 110 of the plurality of semiconductor devices 100 to be used for electricity control and conversion. By way of example, the source pads 110 of the plurality of semiconductor devices 100 may be configured to turn power received from respective gate pads 120 on and off thousands of times per second. The at least one common source pad 280 and the common gate pad 292 establish an input-output (I/O) connection for the source pads 110 and respective gate pads 120 by way of the metal interconnect structure 267. The input-output (I/O) connection enables connection of the multi-chip semiconductor package 200 to an external power electronic circuit, such as a printed circuit board (PCB).

In at least some embodiments, a surface area of the POL-RDL package 250 (e.g., a surface area of the first interconnect layer 260) is substantially equal to a surface area of the footprint 105 defined by the plurality of semiconductor devices 100. For example, the surface area of the POL-RDL package 250 may be between 10% larger than the surface area of the footprint 105 and 10% smaller than the surface area of the footprint, more particularly may be between 5% larger than the surface area of the footprint 105 and 5% smaller than the surface area of the footprint, and even more particularly may be between 2% larger than the surface area of the footprint 105 and 5% smaller than the surface area of the footprint.

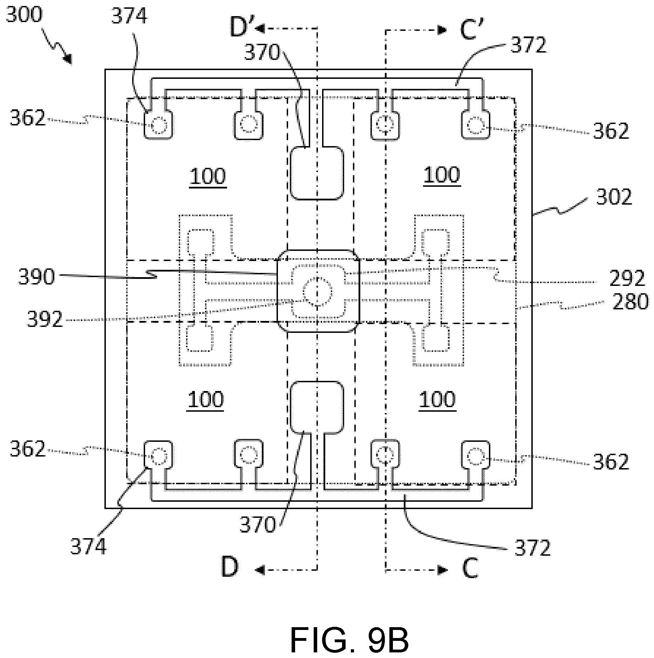

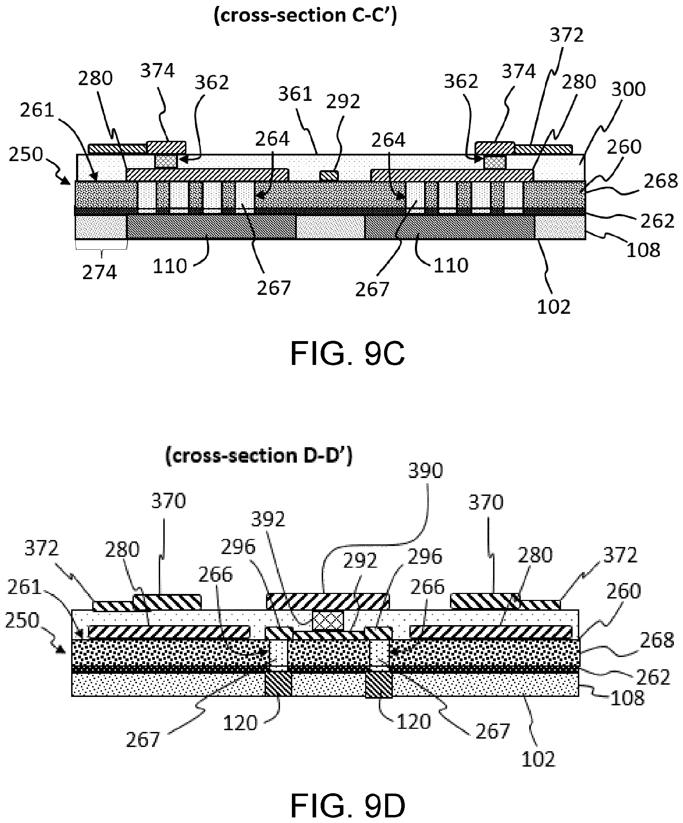

FIGS. 9A though 9D illustrate embodiments of routing 300 of a interconnect layer 302 positioned over the first interconnect layer 260. FIG. 9A illustrates a top view of the interconnect layer 302 and associated routing 300. FIG. 9B illustrates a top translucent view of the interconnect layer 302 and associated routing 300. FIG. 9C illustrates a cross-sectional view of the interconnect layer 302 and associated routing 300 taken along line C-C', and FIG. 9D illustrates a cross-sectional view of the of the interconnect layer 302 and associated routing 300. The interconnect layer 302 is layered on the POL-RDL package 250 (and the first interconnect layer 260 specifically), and includes pads and trace connections similar to components shown in the multi-chip semiconductor package 200 of FIGS. 1-8.

The interconnect layer 302 is applied over the first interconnect layer 260 of the POL-RDL package 250. The interconnect layer 302 includes at least one package contact pad 370 and a package gate pad 390 which facilitate connection of the multi-chip semiconductor package 200 to external power electronic circuitry. The electrical connections include one or more of soldering, sintering, copper-bonding, copper-clipping and the like. In some embodiments, additional interconnect layers may be laminated over the interconnect layer 302 to facilitate more complex routing from the at least one package contact pad 370 and the package gate pad 390. In some embodiments, the at least one package contact pad 370 is a Kelvin contact.

Trace connections 372 extend from the at least one package contact pad 370 to attachment pads 374, and may have any number of branches and bends to establish an electrical connection to underlying structures such as the common source pad 280 of the first interconnect layer 260. The common source pad 280 of the first interconnect layer 260 is electrically connected to the attachment pads 374 by metal interconnect via pathways 362 extending through the interconnect layer 302. The interconnect via pathways 362 are aligned with the at least one common source pad 280 for deposition of a metal interconnect structure that extends through the interconnect via pathways 362.

The interconnect layer 302 includes gate via pathways 392 for connecting the common gate pad 292 to the package gate pad 390 on the interconnect layer 302. In some embodiments, the metal interconnect structure is formed by filling the interconnect via pathways 362 and the gate via pathways 392 with a conductive material (i.e., conductive epoxy, paste, or solder and the like). In some embodiments, the metal interconnect structure is formed during deposition of the at least one package contact pad 370, trace connections 372, attachment pads 374 and the package gate pad 390.

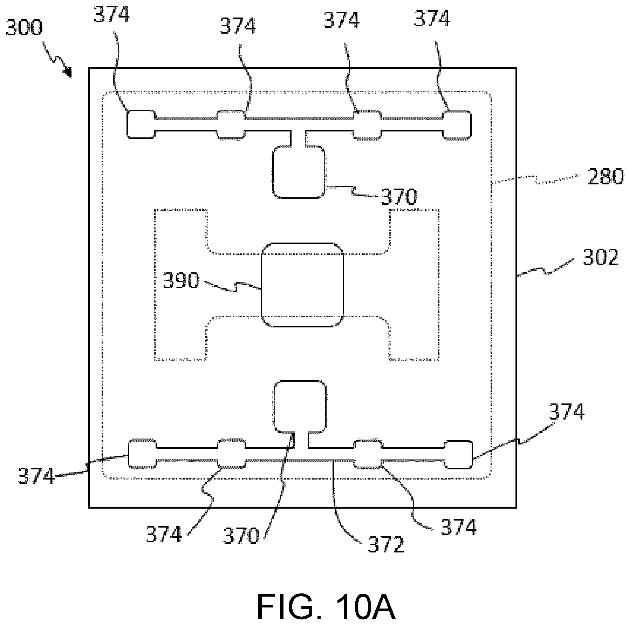

The overhang region 274 and greater surface area of the POL-RDL package 250 facilitate complex routing. As shown in Fig. 9B, the trace connections 372 extend into the overhang region, however it is understood that the trace connections 372 may extend across the at least one common source pad 280 of the first interconnect layer 260. By way of example, but not limitation, FIG. 10A illustrates an embodiment where the trace connections 372 extend across the at least one common source pad 280 of the first interconnect layer 260.

Referring back to FIGS. 9A and 9B, the trace connections 372 at least partially extend into the overhang region 274, and the gate bridge 290 has an I-shape. Each of the gate contacts 296 and the trace connections 294 of the gate bridge 290 are equidistant from the common gate pad 292 such that the gate contacts 296 have the same resistivity. In the illustrated embodiment, the interconnect layer 302 includes two common contact pads 370, and each common contact pad 370 is connected to two corresponding semiconductor devices 100 by the attachment pads 374 and the trace connections 372. In some embodiments, there is at least one attachment pad 374 for each semiconductor device 100. The two common contact pads 370 and the common gate pad 292 are configured as an input-output (I/O) connection for the multi-chip semiconductor package 200 to external power electronic circuitry.

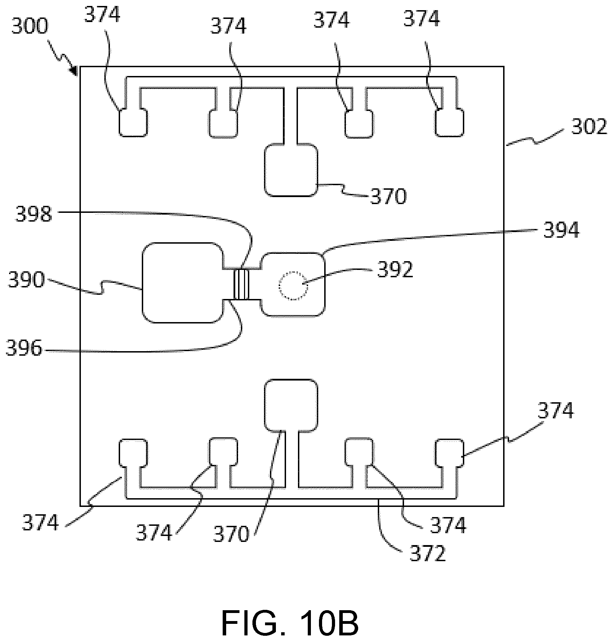

As shown in FIG. 10B, in some embodiments, a gate attachment pad 394 is electrically connected to the common gate pad 292 of the gate bridge 290 (as shown in FIG. 9B) by the gate via pathways 392. The package gate pad 390 is electrically connected to the gate attachment pad 394 by a trace connection 396. In some embodiments, the trace connection 396 includes a surface-mounted resistor 398. In some embodiments, the resistor 398 can be connected post-fabrication, enabling resistance values to be changed to meet different application needs post-fabrication. In some embodiments, the trace connection 396 includes attachment pads for mounting the surface-mounted resistor 398 post-fabrication.

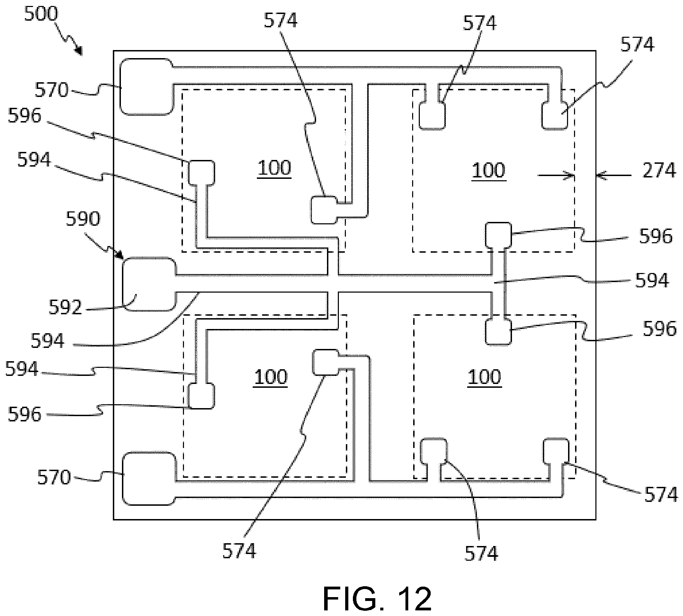

FIGS. 11 and 12 illustrate further embodiments of routing (400, 500) on the interconnect layer 302. In FIGS. 11 and 12, the at least one common source pad 280 is omitted for purposes of clarity in the figures.

As shown in FIG. 11, one embodiment of routing 400 includes two common source or Kelvin pads 470, and each common contact pad 470 is connected to two corresponding semiconductor devices 100 by trace connections 472. A gate bridge 490 includes a common gate pad 492 at least partially disposed in the overhang region 274 and gate contacts 496 connected by a trace connection 494 to each of the corresponding semiconductor devices 100.

As shown in FIG. 12, another embodiment of a routing 500 includes two common contact or Kelvin pads 570 at least partially disposed in the overhang region 274, and each common contact pad 570 is connected to two corresponding semiconductor devices 100 by the trace connections 572. In some embodiments, the two common contact pads 570 are Kelvin contacts. A gate bridge 590 includes a common gate pad 592 at least partially disposed in the overhang region 274 and gate contacts 596 connected by a trace connection 594 to each of the corresponding semiconductor devices 100.

The overhang region 274 and greater surface area of the POL-RDL package 250 facilitates using a wide range of common gate pads (292, 492, 592), common contact pads (370, 470, 570) and associated trace connections (294, 494, 594, 372, 472, 572). Placement of the common gate pads (292, 492, 592) and the at least one package contact pad 370 at least partially on the overhang region 274 also facilitates improved creepage control between components. The POL-RDL package 250 also enables an improved elastic (Young's) modulus of the first interconnect layer 260, which reduces bonding stress on the semiconductor devices 100. The first interconnect layer 260 of the POL-RDL package 250 may be polyimide, which has an elastic modulus of approximately 2.5 GPa, whereas the semiconductor devices 100, which may be SiO₂, may have an elastic modulus of approximately 70 GPa. The lower elastic modulus is capable of absorbing bonding stress, thereby reducing bonding stress on the semiconductor devices 100.The POL-RDL package 250 can thus buffer the stresses during wire bonding to protect semiconductor devices 100.

The trace connections (294, 494, 594, 372, 472, 572) may have varying resistivity values and various trace configuration structures. Using different types of trace configurations enables selectively tuning of the resistivity value between the common gate pad (292, 492, 592) and gate contacts (296, 496, 596). The common gate pads and common contact pads may be subsequently connected to package gate pads and package contact pads on additional interconnect layers. Notably, additional resistance reduces crosstalk, thus improving efficiency of the semiconductor devices 100. In accordance with the embodiments described herein, the resistance values can be selectively adjusted for specific applications without altering the semiconductor devices 100 during fabrication and assembly. This allows for simplified fabrication of the plurality of semiconductor devices 100 and binning during fabrication.

For example, the resistivity value of the trace connections (294, 494, 594, 372, 472, 572) can be altered by depositing the trace connection with material having different resistivities, by modifying a width of the trace connection, and/or by modifying a deposition thickness of the trace connection. An exemplary trace connection (294, 494, 594, 372, 472, 572) having a length of 2 mm, a width of 35 mm and a thickness of 10 mm has a resistance of approximately 0.1 Ω. In some embodiments, the trace connection (294, 494, 594, 372, 472, 572) has a thickness in the range of 5-25 mm, and a trace width of approximately 25 mm. In some embodiments, the trace connection (294, 494, 594, 372, 472, 572) deposition depth is in a range from 50 nanometers (nm) to 50 micrometers (µm). In some embodiments, the resistivity value of the trace connections (294, 494, 594, 372, 472, 572) is tuned or altered by changing the volume of the trace connection (294, 494, 594, 372, 472, 572), changing the cross-sectional area of the trace connection (294, 494, 594, 372, 472, 572), and/or changing the material of the trace connection (294, 494, 594, 372, 472, 572). In some embodiments, the trace connection (294, 494, 594, 372, 472, 572) is made from a combination of a first material having a first resistivity value and a second material having a second resistivity value, and the second material is laminated or otherwise layered over the first material. The resistivity value of the trace connection (294, 494, 594, 372, 472, 572) may be selectively adjustable within a range of 10mΩ (micro-ohms) to 100mΩ. In some embodiments, the trace connection (294, 494, 594, 372, 472, 572) is a resistor. Further, in some embodiments, the trace connection (294, 494, 594, 372, 472, 572) is a surface-mounted resistor. In some embodiments, the resistor 176 can be connected post-fabrication, enabling resistance values to be changed to meet different application needs post-fabrication.

To establish a proper connection to external power electronic circuitry, the at least one common source pad 280 and the common gate pad 292 of the gate bridge 290 must have a sufficient surface area to make the electrical connection. However, the complexity and the surface area of the at least one common source pad 280 and the gate bridge 290 are ultimately limited by the overall surface area of the first interconnect layer 260. By way of example, in at least some known semiconductor assemblies, gate pads in a POL package may have a surface area of up to 0.6 square millimeters (mm²) without the benefit of the overhang region 274. Without the benefit of the additional surface area provided by the overhang region 274, a larger gate pad would necessarily reduce the available area for placement of a source pad, resulting in a lower current rating of each of the multi-chip semiconductor package 200. In contrast, in at least some of the embodiments described herein, the common gate pad 292 of the gate bridge 290, given the benefit of the overhang region 274, has a surface area in the range of 0.5 mm² to 1.5 mm² while still maintaining the current rating of the multi-chip semiconductor package 200. The overhang region 274 of the POL-RDL package 250 allows for redistribution and more complex configurations of the common gate pad 292 of the gate bridge 290 while still maintaining the current rating of the semiconductor device 100 as shown in FIGS. 9-12. Similar to the gate bridge 290, the overhang region 274 of the POL-RDL package 250 allows for redistribution and more complex routing configurations of additional interconnect layers while still maintaining the current rating of the multi-chip semiconductor package 200 as shown in FIGS. 9-12.

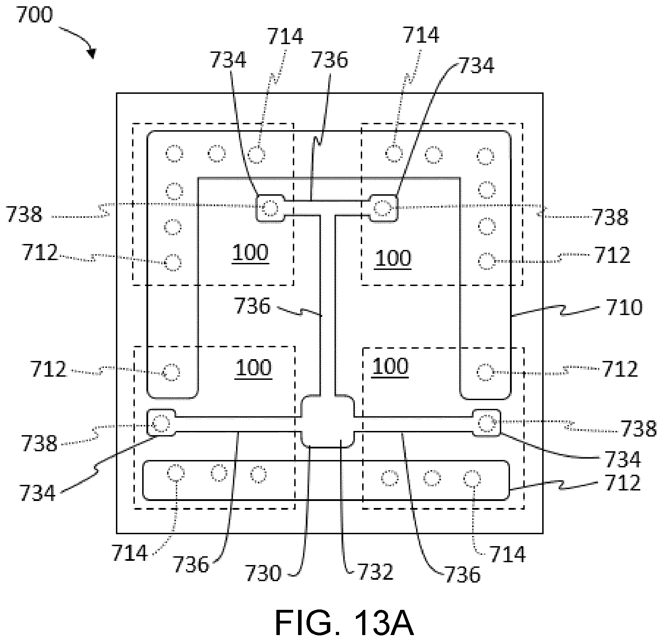

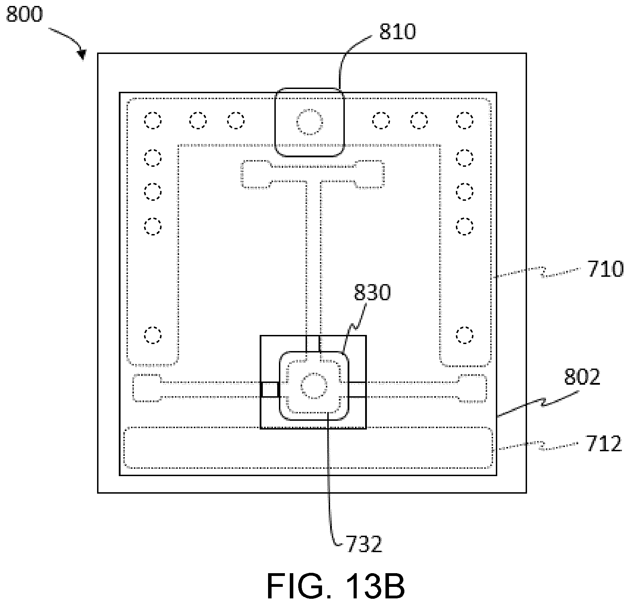

FIG. 13A illustrates an alternative embodiment of routing 702 disposed on a first interconnect layer, and FIG. 13B illustrates associated routing 800 of a interconnect layer disposed over the first interconnect layer. The first and interconnect layers include components similar to the first interconnect layer 260 and the interconnect layer 302 previously described with reference to FIGS. 1-10B.

As shown in FIG. 13A, the routing 700 of the first interconnect layer includes a first common source pad 710, a second common source pad 712 and a gate bridge 730. The common source pads (710, 712) are electrically connected to underlying semiconductor devices 100 by source via pathways 714 extending through the first interconnect layer. The gate bridge 730 includes a common gate pad 732 and gate contacts 734 connected by trace connections 736. The trace connections 736 are electrically connected to underlying semiconductor devices 100 by gate via pathways 738 extending through the first interconnect layer. As shown in FIG. 13B, the routing 800 of the interconnect layer includes a package contact pad 810 electrically connected to the first common source pad 710 and second common source pad 712, and a package gate pad 830 electrically connected to the common gate pad 732. The package contact pad 810 is electrically connected to the first common source pad 710 and second common source pad 712 by an intermediate metal interconnect layer 802.

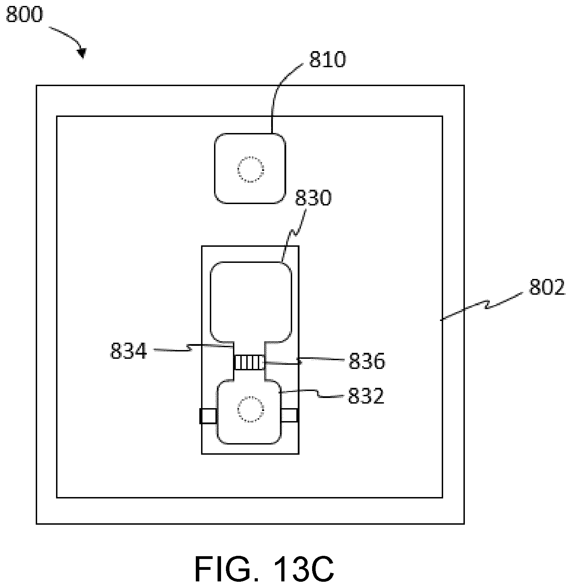

As shown in FIG. 13C, in some embodiments a gate attachment pad 832 is electrically connected to the common gate pad 732 (of FIG. 13A), and the gate attachment pad 832 is connected to the package gate pad 830 by a trace connection 834. In some embodiments, the trace connection 834 includes a surface-mounted resistor 836. In some embodiments, the resistor 836 can be connected post-fabrication, enabling resistance values to be changed to meet different application needs post-fabrication. In some embodiments, the trace connection 834 includes attachment pads for mounting the surface-mounted resistor 836 post-fabrication.

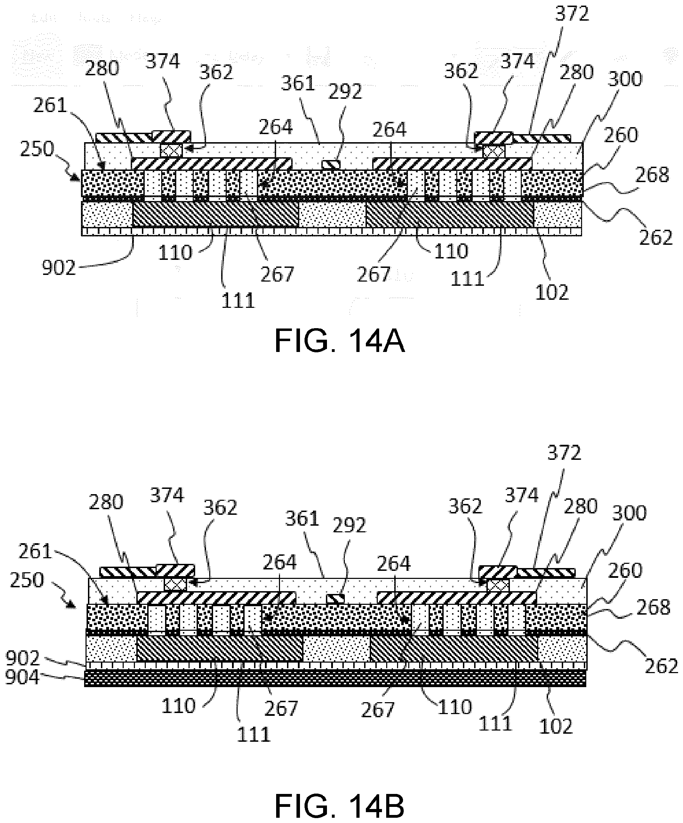

FIGS. 14A-14B illustrate cross-sectional views of backside structures 900 connected to a bottom surface 111 of the semiconductor devices 100. The cross-sectional views are taken along line C-C' of FIG. 9B.

As shown in FIG. 14A, the bottom surface 111 of the semiconductor devices 100 includes a drain pad and remains exposed. A sputter layer 902 is sputtered on the bottom surface 111 of the drain pad. The sputter layer 902 facilitates electrical and thermal contact to the backside using solder, sinter silver or conductive paste. The sputter layer 902 substantially covers the entire bottom surface 111 of the semiconductor devices 100, and in some embodiments, the sputter layer 902 substantially covers the molding. As shown in FIG. 14B, an electrically conductive plate 904 is then applied to the sputter layer 902. In some embodiments, the electrically conductive plate 720 is a direct-bond copper DBC-type substrate.

As shown in FIG. 14A, sputter layer 902 and the electrically conductive plate 904 are applied to the bottom surface 111 of the semiconductor devices 100 prior to applying the molding 102.As shown in FIG. 14B, the molding 102 extends below the bottom surface 111 of the semiconductor devices 100 and the bottom surface 111 of the semiconductor devices 100 remains partially exposed such that a partial encasement is formed. The sputter layer 902 is filled within gaps of the encasement such that the sputter layer 902 is co-planar with the molding 102. The electrically conductive plate 904 is then applied to the sputter layer 902.

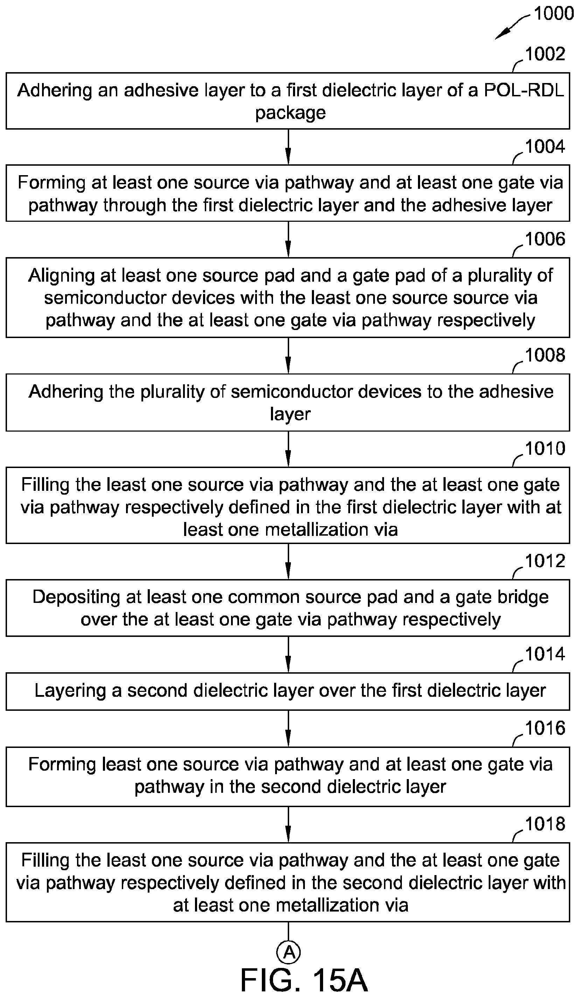

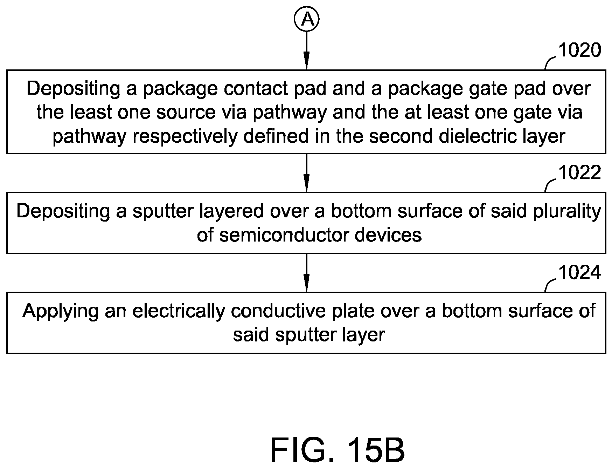

FIGS. 15A-15B illustrate one embodiment of a method 1000 of manufacturing a multi-chip semiconductor package, such as the previously described multi-chip semiconductor package 200. The method 1000 includes adhering 1002 an adhesive layer to a first interconnect layer of a POL-RDL package and forming 1004 at least one source via pathway and at least one gate via pathway through the first interconnect layer and the adhesive layer.

The method 1000 further includes aligning 1006 at least one source pad and a gate pad of a plurality of semiconductor devices with the least one source via pathway and the at least one gate via pathway respectively, and adhering 1008 the plurality of semiconductor devices to the adhesive layer. The method further includes filling 1010 the least one source via pathway and the at least one gate via pathway respectively defined in the first interconnect layer with at least one metallization via. The method 1000 further includes depositing 1012 at least one common source pad and a gate bridge over the at least one gate via pathway respectively.

In some embodiments, the method 1000 further includes layering 1014 a interconnect layer over the first interconnect layer and forming 1016 least one source via pathway and at least one gate via pathway in the interconnect layer. The method 1000 further includes filling 1018 the least one source via pathway and the at least one gate via pathway respectively defined in the interconnect layer with at least one metallization via. The method 1000 further includes depositing 1020 a package contact pad and a package gate pad over the least one source via pathway and the at least one gate via pathway respectively defined in the interconnect layer.

In some embodiments, the method 1000 further includes depositing 1022 a sputter layer layered over a bottom surface of said plurality of semiconductor devices, said sputter layer electrically connected to drain connections of said at least one common source pad of said plurality of semiconductor devices. In some embodiments, the method 1000 further includes applying 1024 an electrically conductive plate over a bottom surface of said sputter layer.

In some embodiments, the metallization layers are formed through a combination of sputtering and electroplating applications, although it is recognized that other electroless methods of metal deposition could also be used. For example, a titanium adhesion layer and a copper seed layer may first be applied via a sputtering process, followed by an electroplating process that increases a thickness of the copper to a desired level. The applied metal material is then subsequently patterned into metal interconnects having a desired shape and that function as vertical feed-throughs formed through the interconnect layer and the adhesive layer.

The above-described embodiments overcome at least some disadvantages of semiconductor devices. Specifically, the embodiments improve surface bonding onto contact pads of a POL structure. In particular, the overhang region of the POL structure reduces bonding stresses on the semiconductor devices. The overhang region of the POL structure allows for redistribution of the components of the POL-RDL package and the second laminated interconnect layers and allows for contact pads having a greater surface areas. The overhang region also allows for a wider range of utilization of trace connections with varying resistivity.

The POL-RDL package also allows for multiple semiconductor devices to operate as a single device having a common gate pad and a common source pad. The individual semiconductor devices can be binned and grouped into devices having similar characteristics, thereby eliminating devices that have wafer defects. This permits the formation of multi-chip semiconductor packages that go beyond practical yield limits as opposed to fabricating a single large and complex semiconductor package. Furthermore, the multi-chip semiconductor device allows for 5mOHM device when tiled together. By way of example, but not limitation, binning four 20mOHM semiconductor devices into the multi-chip semiconductor package and connecting the semiconductor devices in parallel with the common gate pad and the common source pad results in a 5mOHM device.

As previously set forth. combining together multiple semiconductor devices into a multi-chip semiconductor package requires matching semiconductor devices having similar characteristics due to semiconductor manufacturing and fabrication processes inherently having yield variance of the individual semiconductor devices. In addition density limitations of multi-chip semiconductor package manufacturing and assembly increases complexity of multi-chip semiconductor package designs. Such factors may alter the characteristics of the semiconductor device. The POL-RDL package and the described systems and methods facilitate tiling semiconductor devices together. Each semiconductor device may be individually binned for improved packaging without having to overcome variances in defect densities of larger semiconductor devices.

The methods, systems, and compositions disclosed herein are not limited to the specific embodiments described herein, but rather, steps of the methods, elements of the systems, and/or elements of the compositions may be utilized independently and separately from other steps and/or elements described herein.

Although specific features of various embodiments may be shown in some drawings and not in others, this is for convenience only. Moreover, references to "one embodiment" in the above description are not intended to be interpreted as excluding the existence of additional embodiments that also incorporate the recited features. In accordance with the principles of the disclosure, any feature of a drawing may be referenced and/or claimed in combination with any feature of any other drawing.

## Claims

1. A multi-chip semiconductor package (200) comprising:
an interconnect layer (260) having an upper surface (261) and a bottom surface, wherein said interconnect layer comprises a dielectric material,
at least one common source pad (280) disposed on said upper surface of said interconnect layer;
at least one common gate pad (292) disposed on said upper surface of said interconnect layer; and
a plurality of semiconductor devices (100) each comprising a gate pad (120) and at least one source pad (110) adhered onto said interconnect layer;
wherein said source pads of said plurality of semiconductor devices are electrically connected to said at least one common source pad, and wherein said source pads of said plurality of semiconductor devices are electrically connected in parallel with one another;
wherein said gate pads of said plurality of semiconductor devices are electrically connected to said common gate pad, and wherein said gate pads of said plurality of semiconductor devices are electrically connected in parallel with one another; and
further comprising a plurality of gate contacts (296) disposed on said interconnect layer (260) and electrically connected to said common gate pad (292) by trace connections (294), wherein each gate pad (120) of each of said plurality of semiconductor devices (100) is connected to an associated gate contact of said plurality of gate contacts,
wherein at least one trace connection (294) of said trace connections comprises one of a surface-mount resistor and a thin-film resistor to balance resistivity values of the trace connections.

2. The multi-chip semiconductor package (200) of claim 1 further comprising an adhesive layer (262) disposed on said bottom surface of said interconnect layer (260).

3. The multi-chip semiconductor package (200) of claim 1, wherein said plurality of gate contacts (296) are equidistant from said common gate pad (292).

4. The multi-chip semiconductor package (200) of any preceding claim, wherein said gate trace connections (294) have an equal resistivity value.

5. The multi-chip semiconductor package (200) of claim 1, wherein said common gate pad (292) and said at least one common source pad (280) are configured to be electrically connected to external power electronic circuitry such that a POL-RDL package (250) operates as a singular processing unit.

6. The multi-chip semiconductor package (200) of claim 5 further comprising a Kelvin contact (470) electrically connected to said at least one common source pad (280) to facilitate connecting said at least one common source pad to the external power electronic circuitry.

7. The multi-chip semiconductor (200) package of claim 1, further comprising:
an additional interconnect layer (302) disposed over said interconnect layer (260);
a package gate pad (390) disposed on said additional interconnect layer and electrically connected to said common gate pad (292) of said interconnect layer; and
at least one package source pad (280) disposed on said additional interconnect layer and electrically connected to said at least one common source pad of said interconnect layer.

8. The multi-chip semiconductor package (200) of claim 7, wherein said package gate pad (390) is electrically connected to a gate attachment pad (394) by a trace connection (396), said gate attachment pad connected to said common gate pad of said interconnect layer (260).

9. The multi-chip semiconductor package (200) of claim 8, wherein said trace connection (396) electrically connected to said package gate pad (390) comprises one of a surface-mount resistor and a thin-film resistor.

10. The multi-chip semiconductor package (200) of any one of claims 4-9, wherein said package gate pad (390) and said at least one package source pad are configured to be electrically connected to external power electronic circuitry such that a POL-RDL package (250) operates as a singular power switching unit.

11. The multi-chip semiconductor package (200) of any preceding claim, wherein a surface area of said interconnect layer (260) is substantially equal to a surface area of a footprint defined by the plurality of semiconductor devices (100).

12. The multi-chip semiconductor package (200) of any preceding claim, wherein a backside of the semiconductor devices (100) are electrically connected together by an electrically conductive plate (720) such that a common drain connection is formed.

13. The multi-chip semiconductor package (200) of claim 12 further comprising a molding (102) disposed between said interconnect layer (260) and said electrically conductive plate (720).

## Patentansprüche

1. Multi-Chip-Halbleitergehäuse (200), umfassend:
eine Zusammenschaltungsschicht (260), die eine obere Oberfläche (261) und eine untere Oberfläche aufweist, wobei die Zusammenschaltungsschicht ein dielektrisches Material umfasst,
mindestens eine gemeinsame Source-Kontaktfläche (280), die auf der oberen Oberfläche der Zusammenschaltungsschicht angeordnet ist;
mindestens eine gemeinsame Gate-Kontaktfläche (292), die auf der oberen Oberfläche der Zusammenschaltungsschicht angeordnet ist; und
eine Vielzahl von Halbleiterbauelementen (100), die jeweils eine Gate-Kontaktfläche (120) und mindestens eine Source-Kontaktfläche (110), die auf die Zusammenschaltungsschicht geklebt sind, umfassen;
wobei die Source-Kontaktflächen der Vielzahl von Halbleiterbauelementen mit der mindestens einen gemeinsamen Source-Kontaktfläche elektrisch verbunden sind, und wobei die Source-Kontaktflächen der Vielzahl von Halbleiterbauelementen parallel zueinander elektrisch verbunden sind;
wobei die Gate-Kontaktflächen der Vielzahl von Halbleiterbauelementen mit der gemeinsamen Gate-Kontaktfläche elektrisch verbunden sind, und wobei die Gate-Kontaktflächen der Vielzahl von Halbleiterbauelementen parallel zueinander elektrisch verbunden sind; und
ferner umfassend eine Vielzahl von Gate-Kontakten (296), die auf der Zusammenschaltungsschicht (260) angeordnet sind und mit der gemeinsamen Gate-Kontaktfläche (292) durch Spurverbindungen (294) elektrisch verbunden sind, wobei jede Gate-Kontaktfläche (120) jedes der Vielzahl von Halbleiterbauelementen (100) mit einem zugeordneten Gate-Kontakt der Vielzahl von Gate-Kontakten verbunden ist,
wobei mindestens eine Spurverbindung (294) der Spurverbindungen einen von einem oberflächenmontierten Widerstand und einem Dünnschicht-Widerstand umfasst, um die spezifischen Widerstandswerte der Spurverbindungen auszugleichen.

2. Multi-Chip-Halbleitergehäuse (200) nach Anspruch 1, ferner umfassend eine Klebeschicht (262), die auf der unteren Oberfläche der Zusammenschaltungsschicht (260) angeordnet ist.

3. Multi-Chip-Halbleitergehäuse (200) nach Anspruch 1, wobei die Vielzahl von Gate-Kontakten (296) von der gemeinsamen Gate-Kontaktfläche (292) gleichweit entfernt sind.

4. Multi-Chip-Halbleitergehäuse (200) nach einem der vorhergehenden Ansprüche, wobei die Gate-Spurverbindungen (294) einen gleichen spezifischen Widerstandswert aufweisen.

5. Multi-Chip-Halbleitergehäuse (200) nach Anspruch 1, wobei die gemeinsame Gate-Kontaktfläche (292) und die mindestens eine gemeinsame Source-Kontaktfläche (280) dazu konfiguriert sind, mit externen elektronischen Leistungsschaltungen elektrisch verbunden zu sein, so dass ein POL-RDL-Gehäuse (250) als eine singuläre Verarbeitungseinheit betrieben wird.

6. Multi-Chip-Halbleitergehäuse (200) nach Anspruch 5, ferner umfassend einen Kelvin-Kontakt (470), der mit mindestens einer gemeinsamen Source-Kontaktfläche (280) elektrisch verbunden ist, um die Verbindung der mindestens einen gemeinsamen Source-Kontaktfläche mit den externen elektronischen Leistungsschaltungen zu ermöglichen.

7. Multi-Chip-Halbleitergehäuse (200) nach Anspruch 1, ferner umfassend:
eine zusätzliche Zusammenschaltungsschicht (302), die auf der Zusammenschaltungsschicht (260) angeordnet ist;
eine Gehäuse-Gate-Kontaktfläche (390), die auf der zusätzlichen Zusammenschaltungsschicht angeordnet ist und mit der gemeinsamen Gate-Kontaktfläche (292) der Zusammenschaltungsschicht elektrisch verbunden ist; und
mindestens eine Gehäuse-Source-Kontaktfläche (280), die auf der zusätzlichen Zusammenschaltungsschicht angeordnet ist und mit der mindestens einen gemeinsamen Source-Kontaktfläche der Zusammenschaltungsschicht elektrisch verbunden ist.

8. Multi-Chip-Halbleitergehäuse (200) nach Anspruch 7, wobei die Gehäuse-Gate-Kontaktfläche (390) mit einer Gate-Anbringungskontaktfläche (394) durch eine Spurverbindung (396) elektrisch verbunden ist, wobei die Gate-Anbringungskontaktfläche mit der gemeinsamen Gate-Kontaktfläche der Zusammenschaltungsschicht (260) elektrisch verbunden ist.

9. Multi-Chip-Halbleitergehäuse (200) nach Anspruch 8, wobei die Spurverbindung (396), die mit der Gehäuse-Gate-Kontaktfläche (390) elektrisch verbunden ist, einen von einem oberflächenmontierten Widerstand und einem Dünnschicht-Widerstand umfasst.

10. Multi-Chip-Halbleitergehäuse (200) nach einem der vorhergehenden Ansprüche 4 bis 9, wobei die Gehäuse-Gate-Kontaktfläche (390) und die mindestens eine Gehäuse-Source-Kontaktfläche dazu konfiguriert sind, mit externen elektronischen Leistungsschaltungen elektrisch verbunden zu sein, so dass ein POL-RDL-Gehäuse (250) als eine singuläre Leistungsschalteinheit betrieben wird.

11. Multi-Chip-Halbleitergehäuse (200) nach einem der vorhergehenden Ansprüche, wobei ein Flächeninhalt der Zusammenschaltungsschicht (260) im Wesentlichen gleich einem Flächeninhalt einer Anschlussfläche ist, die durch die Vielzahl von Halbleiterbauelementen (100) definiert ist.

12. Multi-Chip-Halbleitergehäuse (200) nach einem der vorhergehenden Ansprüche, wobei die Rückseiten der Halbleiterbauelemente (100) durch eine elektrisch leitende Platte (720) elektrisch miteinander verbunden sind, so dass sich eine gemeinsame Drain-Verbindung bildet.

13. Multi-Chip-Halbleitergehäuse (200) nach Anspruch 12, ferner umfassend ein Formteil (102), das zwischen der Zusammenschaltungsschicht (260) und der elektrisch leitenden Platte (720) angeordnet ist.

## Revendications

1. Boîtier de semi-conducteur multipuce (200), comprenant :
une couche d'interconnexion (260) présentant une surface supérieure (261) et une surface inférieure, ladite couche d'interconnexion comprenant un matériau diélectrique,
au moins une pastille de source commune (280) disposée sur ladite surface supérieure de ladite couche d'interconnexion ;
au moins une pastille de grille commune (292) disposée sur ladite surface supérieure de ladite couche d'interconnexion ; et
une pluralité de dispositifs à semi-conducteurs (100), chacun comprenant une pastille de grille (120) et au moins une pastille de source (110) collées sur ladite couche d'interconnexion ;
dans lequel lesdites pastilles de source de ladite pluralité de dispositifs à semi-conducteurs sont connectées électriquement à ladite au moins une pastille de source commune, et dans lequel lesdites pastilles de source de ladite pluralité de dispositifs à semi-conducteurs sont connectées électriquement en parallèle les unes avec les autres ;
dans lequel lesdites pastilles de grille de ladite pluralité de dispositifs à semi-conducteurs sont connectées électriquement à ladite pastille de grille commune, et dans lequel lesdites pastilles de grille de ladite pluralité de dispositifs à semi-conducteurs sont connectées électriquement en parallèle les unes avec les autres ; et
comprenant en outre une pluralité de contacts de grille (296) disposés sur ladite couche d'interconnexion (260) et connectés électriquement à ladite pastille de grille commune (292) par des connexions de piste (294), chaque pastille de grille (120) de chacun de ladite pluralité de dispositifs à semi-conducteurs (100) étant connectée à un contact de grille associé de ladite pluralité de contacts de grille,
dans lequel au moins une connexion de piste (294) desdites connexions de piste comprend l'une d'une résistance montée en surface et d'une résistance en couche mince pour équilibrer les valeurs de résistivité des connexions de piste.

2. Boîtier de semi-conducteur multipuce (200) selon la revendication 1, comprenant en outre une couche adhésive (262) disposée sur ladite surface inférieure de ladite couche d'interconnexion (260).

3. Boîtier de semi-conducteur multipuce (200) selon la revendication 1, dans lequel ladite pluralité de contacts de grille (296) est équidistante de ladite pastille de grille commune (292).

4. Boîtier de semi-conducteur multipuce (200) selon l'une quelconque des revendications précédentes, dans lequel lesdites connexions de piste de grille (294) présentent une valeur de résistivité égale.

5. Boîtier de semi-conducteur multipuce (200) selon la revendication 1, dans lequel ladite pastille de grille commune (292) et ladite au moins une pastille de source commune (280) sont configurées pour être connectées électriquement à des circuits électroniques de puissance externes de sorte qu'un boîtier POL-RDL (250) fonctionne comme une unité de traitement unique.

6. Boîtier de semi-conducteur multipuce (200) selon la revendication 5, comprenant en outre un contact de Kelvin (470) connecté électriquement à ladite au moins une pastille de source commune (280) pour faciliter la connexion de ladite au moins une pastille de source commune aux circuits électroniques de puissance externes.

7. Boîtier de semi-conducteur multipuce (200) selon la revendication 1, comprenant en outre :
une couche d'interconnexion supplémentaire (302) disposée sur ladite couche d'interconnexion (260) ;
une pastille de grille de boîtier (390) disposée sur ladite couche d'interconnexion supplémentaire et connectée électriquement à ladite pastille de grille commune (292) de ladite couche d'interconnexion ; et
au moins une pastille de source de boîtier (280) disposée sur ladite couche d'interconnexion supplémentaire et connectée électriquement à ladite au moins une pastille de source commune de ladite couche d'interconnexion.

8. Boîtier de semi-conducteur multipuce (200) selon la revendication 7, dans lequel ladite pastille de grille de boîtier (390) est connectée électriquement à une pastille de fixation de grille (394) par une connexion de piste (396), ladite pastille de fixation de grille étant connectée à ladite pastille de grille commune de ladite couche d'interconnexion (260).

9. Boîtier de semi-conducteur multipuce (200) selon la revendication 8, dans lequel ladite connexion de piste (396) connectée électriquement à ladite pastille de grille de boîtier (390) comprend l'une d'une résistance montée en surface et d'une résistance en couche mince.

10. Boîtier de semi-conducteur multipuce (200) selon l'une quelconque des revendications précédentes 4 à 9, dans lequel ladite pastille de grille de boîtier (390) et ladite au moins une pastille de source de boîtier sont configurées pour être connectées électriquement à des circuits électroniques de puissance externes de sorte qu'un boîtier POL-RDL (250) fonctionne comme une unité de commutation de puissance unique.

11. Boîtier de semi-conducteur multipuce (200) selon l'une quelconque des revendications précédentes, dans lequel une superficie de ladite couche d'interconnexion (260) est substantiellement égale à une superficie d'une surface de connexion définie par la pluralité de dispositifs à semi-conducteur (100).

12. Boîtier de semi-conducteur multipuce (200) selon l'une quelconque des revendications précédentes, dans lequel les faces arrière des dispositifs à semi-conducteur (100) sont connectées électriquement ensemble par une plaque électriquement conductrice (720) de façon à former une connexion de drain commun.

13. Boîtier de semi-conducteur multipuce (200) selon la revendication 12, comprenant en outre un moulage (102) disposé entre ladite couche d'interconnexion (260) et ladite plaque électriquement conductrice (720).
